# EUROPEAN PATENT APPLICATION

(11) **EP 1 337 043 A2**
(43) Date of publication of application: **20.08.2003**
(21) Application number: 03002877.3
(22) Date of filing: 08.02.2003
(51) Int. Cl.: H03M 1/10

(54) **Failure detection in an analog-digital conversion function of a microcomputer**

(30) Priority: 18.02.2002 JP 2002040713
(71) Applicant: Niles Parts Co., Ltd., Tokyo 143-0015 (JP)
(72) Inventor: Koga, Osamu, c/o NILES PARTS CO., LTD., Tokyo 143-0015 (JP); Uno, Koji, c/o NILES PARTS CO., LTD., Tokyo 143-0015 (JP); Kawamura, Yasuharu, c/o NILES PARTS CO., LTD., Tokyo 143-0015 (JP)
(74) Representative: Luderschmidt, Schüler & Partner

(57) **Abstract**

In a microcomputer 10 including an output port 20 for outputting digital signals and an AD conversion register 18 for converting an analog voltage inputted to an AD input port 16 to a digital signal, the output port 20 and the AD input port 16 are directly connected. The output port 20 is allowed to selectively output H of a power source potential and L of a ground potential. The AD conversion register 18 is judged as being failed when any one of predetermined high order bits of the AD conversion register 18 is not 1 at the H output, or when any of one of the predetermined high order bits is not 0 at the L output. The digital conversion value of this AD conversion register 18 is not used. Thereby, existence/absence of failure of the AD conversion register is detected without using 2 channels for the AD input port.

## Description

### BACKGROUND OF THE INVENTION

### 1. Field of the Invention

This invention relates to a failure detection method of a microcomputer. More particularly, the invention relates to a failure detection method for detecting an analog-digital function of a microcomputer that converts an analog voltage inputted to an AD input port to a digital value and uses it for an internal process.

### 2. Description of Related Art

A microcomputer includes therein an AD conversion register, converts an analog voltage inputted to an AD input port to a digital value, uses it for an internal process and outputs a process result as a digital signal to an output port so that it can be utilized in an external control apparatus.

In such a microcomputer, if open-circuit failure or short-circuit failure occurs in such an AD conversion register, the process result does not correctly reflect the analog voltage value inputted to the AD input port but creates so-called "data disguise" and invites an error of a control operation.

Therefore, it is necessary to confirm whether or not the AD conversion register is normal and whether or not the analog-digital conversion function of the microcomputer operates normally.

Failure of the AD conversion register can be detected when direct write and read to and from the AD conversion register is made by use of known data. However, write is inhibited to the AD conversion register of microcomputers that are generally available, and this method cannot always be used.

To cope with this problem, it may be possible to employ a method that directly and selectively connects the AD input port to GND (ground) and to a power source and confirms the digital conversion value of the AD conversion resister inside the microcomputer. In this case, however, an AD input port for confirmation becomes necessary in addition to the ordinary AD input port for inputting data, and AD input ports of two channels must be provided.

Nonetheless, it is sometimes difficult to provide two channels of AD input ports depending on the circuit scale of the microcomputer.

### SUMMARY OF THE INVENTION

In view of the problem described above, it is therefore an object of the invention to provide a failure detection method of a microcomputer that can detect failure of an analog-digital conversion function due to failure of an AD conversion register even when direct write of the AD conversion register is inhibited, or even when only one channel can be used for an AD input port.

Therefore, a first aspect of the invention provides a failure detection method of a microcomputer by directly connecting an output port outputting digital signals of a microcomputer to an AD input port connected to an internal AD conversion register, and detecting failure of an analog-digital conversion function of the microcomputer on the basis of a state of the AD conversion register with respect to the output of the output port.

A second aspect of the invention provides a failure detection method of a microcomputer by directly connecting an output port outputting digital signals of a microcomputer to an AD input port connected to an internal AD conversion register, judging the AD conversion register as being failed particularly when a digital conversion value by the AD conversion register is smaller than a first predetermined value when H is outputted to the output port, or particularly when the digital conversion value of the AD conversion register is greater than a second predetermined value when L is outputted to the output port, and detecting failure of an analog-digital conversion function of the microcomputer.

A third aspect of the invention provides a failure detection method of a microcomputer by directly connecting an output port outputting digital signals of a microcomputer to an AD input port connected to an internal AD conversion register, judging the AD conversion register as being failed when predetermined high order bits of the AD conversion register is not 1 when H is outputted to the output port, or when predetermined high order bits of the AD conversion register is not 0 when L is outputted to the output port, and detecting failure of an analog-digital conversion function of the microcomputer.

### BRIEF DESCRIPTION OF THE DRAWINGS

Fig. 1 shows a connection state of ports of a microcomputer in an embodiment of the invention;
Fig. 2 shows bit state in an AD conversion register;
Fig. 3 shows a failure judgment process of the AD conversion register; and
Fig. 4 is a flowchart showing a flow of a diagnosis process.

### DESCRIPTION OF PREFERRED EMBODIMENTS

Hereinafter, an embodiment of the invention will be explained.

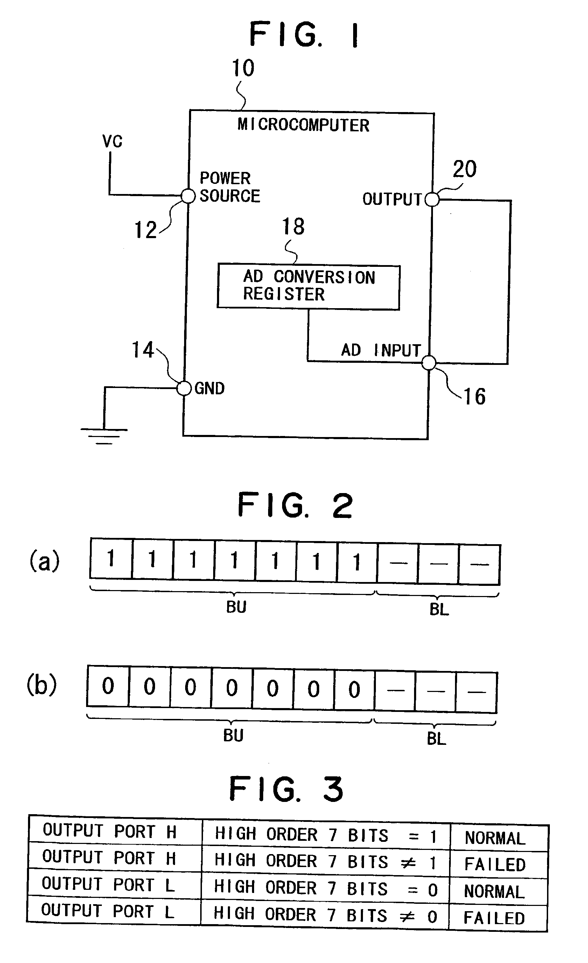

In a microcomputer 10 having its power source terminal 12 connected to a power source VC and its GND terminal 14 grounded, an output port 20 and an AD input port 16 are directly connected to each other to execute diagnosis as shown in Fig. 1. The output port 20 is allowed to selectively output an H output (power source potential) and an L output (ground potential), and failure of an AD conversion register 18 is detected by confirming a bit state of the AD conversion register 18 at this time.

It will be hereby assumed that the power source potential is 5 V and a conversion bit number of the AD conversion register 18 is 10 bits.

First, the AD conversion register 18 is judged as normal if a digital conversion value takes a predetermined value substantially corresponding to a value near 5 V, that is, if all the high order bits BU other than low order 3 bits BL of 10 bits take a value 1 (first predetermined value) when H (= 5 V) is outputted to the output port 20 as shown in Fig. 2(a). On the other hand, the AD conversion register 18 is judged as being failed if any one of the high order bits BU other than the low order 3 bits of the 10 bits does not take the value 1.

The AD conversion register 18 is judged as normal if all the high order bits BU other than the low order 3 bits BL of the 10 bits the digital conversion value take a value 0 (second predetermined value) when L (= 0 V) is outputted to the output port 20 as shown in Fig. 2(b). On the other hand, the AD conversion register 18 is judged as being failed if any one of the high order bits BU other than the low order 3 bits of the 10 bits the digital conversion value does not take the value 0.

Incidentally, the low order 3 bits BL can be neglected as they are within the range of an error.

Fig. 3 shows a failure judgment process of the AD conversion register 18 as a diagnosis table.

The conformation diagnosis described above is conducted as an internal process of the microcomputer 10 in accordance with an instruction from outside after the output port 20 of the microcomputer 10 is directly connected to the AD input port 16.

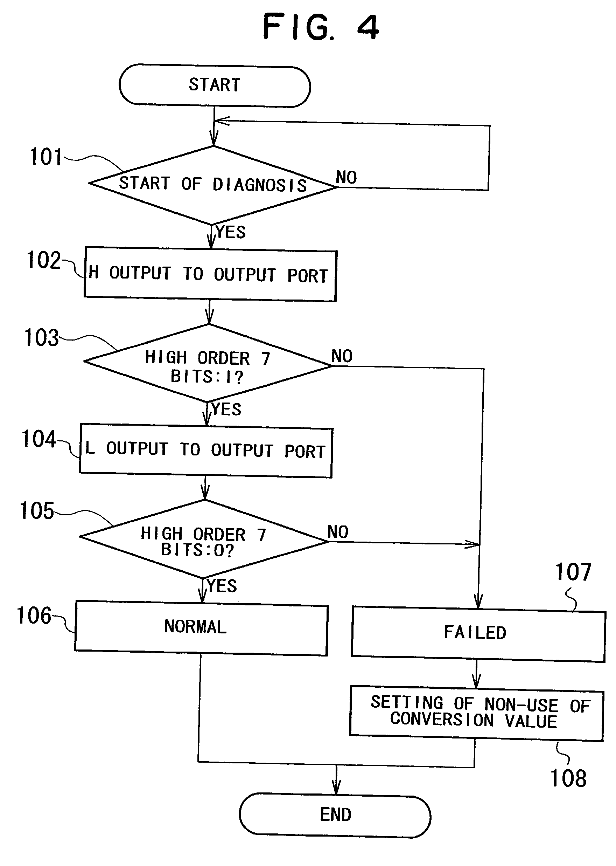

Fig. 4 is a flowchart that shows the flow of the diagnosis process described above.

In Step 101, whether or not a diagnosis start instruction exists is checked. When the instruction exists, H is outputted to the output port 20 in Step 102. In consequence, a 5 V analog voltage is inputted to the AD input port 16.

In Step 103, whether or not all the high order 7 bits of the AD conversion register 18 connected to the AD input port 16 are 1 is checked.

When all the high order 7 bits BU are 1, the flow proceeds to Step 104, and L is outputted to the output port 20. Consequently, the input voltage of the AD input port 16 changes to 0 V.

In Step 105, whether or not all the high order 7 bits of the AD conversion register 18 are 0 is checked.

When all the high order 7 bits BU are 0, the flow proceeds to Step 106, and a report that the AD conversion register 18 is normal is notified, and diagnosis is finished.

On the other hand, if any one of the high order 7 bits BU of the AD conversion register 18 is not 1 in the check of Step 103, or if any one of the high order 7 bits BU of the AD conversion register 18 is not 0 in the check of Step 105, the report that the AD conversion register 18 is failed is notified in Step 107, respectively, and internal setting is changed in Step 108 lest the digital value converted by this AD conversion register 18 is used for the arithmetic process. The diagnosis is then finished.

The report of normality and the report of failure described above are notified through indicator light, for example.

In the embodiment having the construction described above, the output port 20 of the microcomputer 10 is directly connected to the AD input port 16, known data is inputted to the AD input port 16 by selectively setting the output port 20 to H and L, and the state of the predetermined bits (BU) of the AD conversion register 18 is checked. Therefore, the embodiment can detect failure of the AD conversion register 18 no matter whether or not direct write to the AD conversion register 18 can be made, and without increasing the channels of the AD input port. This embodiment can be applied to various kinds of microcomputers.

Incidentally, the embodiment has been explained about the case where the power source potential (potential of H signal) is 5 V, the conversion bit number of the AD conversion register 18 is 10 bits and the check object is the high order 7 bits. However, these values are merely illustrative, and an arbitrary bit number can be selected, whenever necessary, under an arbitrary power source potential. In other words, the object bits to be checked for judging normality/abnormality can be decided appropriately. Since the embodiment described above represents the application at a level of accuracy at which variance of the low order 3 bits can be neglected, the high order 7 bits are confirmed. When higher accuracy is required, an arbitrary bit number may be selected such as confirmation of the high order 8 bits.

In the invention described above, the output port outputting the digital signals of the microcomputer and the AD input port connected to the internal AD conversion register are directly connected to confirm the state of the AD conversion register with respect to the known output of the output port. Therefore, the invention can detect failure of the analog-digital conversion function no matter whether or not direct write of the AD conversion register can be made and without increasing the channels of the AD input port.

The AD conversion register can be judged as being failed particularly when the digital conversion value of the AD conversion register is smaller than the first predetermined value when H is outputted to the output port, or particularly when the digital conversion value of the AD conversion register is greater than the second predetermined value when L is outputted to the output port.

More concretely, the AD conversion register can be judged as being failed when any one of the high order bits are not 1 when H is outputted to the output port, or any one of the high order bits are not 0 when L is outputted to the output port, assuming that the first predetermined value is the value at which all the predetermined high order bits of the AD conversion register are 1 and the second predetermined value is the value at which all the predetermined high order bits of the AD conversion register are 0.

## Claims

1. A failure detection method of a microcomputer comprising:
directly connecting an output port outputting digital signals of a microcomputer to an AD input port connected to an internal AD conversion register, and
detecting failure of an analog-digital conversion function of said microcomputer on the basis of a state of said AD conversion register with respect to the output of said output port.

2. A failure detection method of a microcomputer comprising:
directly connecting an output port outputting digital signals of a microcomputer to an AD input port connected to an internal AD conversion register,
judging said AD conversion register as being failed when a digital conversion value by said AD conversion register is smaller than a first predetermined value when H is outputted to said output port, or when the digital conversion value of said AD conversion register is greater than a second predetermined value when L is outputted to said output port, and
detecting failure of an analog-digital conversion function of said microcomputer.

3. A failure detection method of a microcomputer comprising:
directly connecting an output port outputting digital signals of a microcomputer to an AD input port connected to an internal AD conversion register,
judging said AD conversion register as being failed when predetermined high order bits of said AD conversion register is not 1 when H is outputted to said output port, or when predetermined high order bits of said AD conversion register is not 0 when L is outputted to said output port, and
detecting failure of an analog-digital conversion function of said microcomputer.
